(19) Europäisches Patentamt / European Patent Office / Office européen des brevets

(11) **EP 2 710 393 B1**

(12) **FASCICULE DE BREVET EUROPEEN**

(45) Date de publication et mention de la délivrance du brevet:
**25.03.2015 Bulletin 2015/13**

(21) Numéro de dépôt: **12720887.4**

(22) Date de dépôt: **15.05.2012**

(51) Int Cl.:
*G01R 33/02* (2006.01)          *G01R 33/14* (2006.01)
*H02H 9/00* (2006.01)          *G01R 33/00* (2006.01)

(86) Numéro de dépôt international:
**PCT/EP2012/059029**

(87) Numéro de publication internationale:
**WO 2012/156406 (22.11.2012 Gazette 2012/47)**

(54) **PROCÉDÉ ET SYSTEME DE CONTRÔLE DE L'INSTANT DE MISE SOUS TENSION D'UN DISPOSITIF COMPRENANT UN CIRCUIT MAGNETIQUE**

VERFAHREN UND SYSTEM ZUR STEUERUNG DER EINSCHALTZEIT EINER VORRICHTUNG MIT EINEM MAGNETSCHALTKREIS

METHOD AND SYSTEM FOR CONTROLLING THE TURN-ON TIME OF A DEVICE THAT INCLUDES A MAGNETIC CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.05.2011 FR 1154212**

(43) Date de publication de la demande:
**26.03.2014 Bulletin 2014/13**

(73) Titulaires:
• **Electricité de France**
  **75008 Paris (FR)**
• **Centre National de la Recherche Scientifique (CNRS)**
  **75016 Paris (FR)**

(72) Inventeurs:
• **CAVALLERA, Didier**
  **38000 Grenoble (FR)**
• **COULOMB, Jean-Louis**
  **38330 Saint Ismier (FR)**
• **CHADEBEC, Olivier**
  **38100 Grenoble (FR)**
• **CAILLAULT, Bruno**
  **38320 Herbeys (FR)**
• **ZGAINSKI, François-Xavier**
  **38140 La Murette (FR)**

(74) Mandataire: **Regimbeau**
  **139, rue Vendôme**
  **69477 Lyon Cedex 06 (FR)**

(56) Documents cités:
DE-A1- 3 614 057          DE-A1- 4 312 764
DE-A1- 19 641 116

• **CHILLET C ET AL: "Magnetic Moment and Reluctance Network Mixed Method Applied to Transformer's Modeling", IEEE TRANSACTIONS ON MAGNETICS, IEEE SERVICE CENTER, NEW YORK, NY, US, vol. 41, no. 5, 1 mai 2005 (2005-05-01), pages 1428-1431, XP011131949, ISSN: 0018-9464, DOI: 10.1109/TMAG. 2005.844542**

EP 2 710 393 B1

**Description**

**DOMAINE DE L'INVENTION**

La présente invention concerne un procédé et un système de contrôle de l'instant de mise sous tension d'un dispositif comprenant un circuit magnétique et au moins une bobine conductrice.

**ARRIERE PLAN DE L'INVENTION**

Lors de la remise sous tension d'un transformateur de puissance sur un réseau de transport ou de distribution d'électricité, il est connu que des surintensités transitoires peuvent apparaître, en raison d'une différence entre les valeurs des flux rémanents dans chaque partie du circuit magnétique et les flux générés par les tensions imposées aux bornes de chaque enroulement.

Ces surintensités riches en harmoniques peuvent dans certaines configurations du réseau présenter des valeurs largement supérieures aux niveaux admissibles par le transformateur.

Ces surintensités peuvent par ailleurs créer des efforts électrodynamiques importants au niveau des bobinages, conduisant à une dégradation accélérée du transformateur (déformation, déplacement des bobinages).

Ces problèmes de surintensités et de surtensions peuvent également être rencontrés dans le cadre d'autres dispositifs électriques comportant un circuit magnétique et des bobines électriques (démarrages de machines électriques).

A titre d'illustration, on s'intéresse ci-après au cas d'un transformateur monophasé.

Avant la mise sous tension, le flux $\Phi$ dans le matériau ferromagnétique qui constitue le circuit magnétique a une valeur $\Phi_r$ appelé flux rémanent.

Ce flux rémanent dépend des conditions de la mise hors tension du transformateur, qui ne sont généralement pas maîtrisées, ainsi que de la nature du circuit magnétique (telle que sa géométrie) et des paramètres intrinsèques du matériau le constituant.

Ce flux rémanent est susceptible d'évoluer au cours du temps, notamment en raison de contraintes extérieures pouvant s'exercer sur le transformateur hors tension (par exemple sous l'influence de dispositifs électriques au voisinage du transformateur).

A la mise sous tension à t=0, la tension appliquée étant une tension alternative, la tension aux bornes du bobinage inducteur peut s'écrire :

$$V_0 = V\sqrt{2}\cos(\alpha)$$

où :

V est la valeur efficace de la tension imposée
$\alpha$ est l'angle représentant la phase au moment de la mise sous tension $V_0$ a donc une valeur dépendant uniquement de $\alpha$.

A cette valeur correspond un flux $\Phi_0$ imposé dans le circuit magnétique. L'équation de fonctionnement est la suivante :

$$V\sqrt{2}\cos(\omega t + \alpha) = R\,i(t) + n\frac{d\phi(t)}{dt}$$

où :

$\omega$ est la pulsation de la tension
R est la résistance totale du circuit électrique y compris celle du bobinage inducteur
n est le nombre de spires du bobinage inducteur
$\Phi$ est le flux moyen dans le circuit magnétique

Il est connu que l'expression du flux, moyennant quelques approximations, est la suivante :

$$\phi(t) = \frac{V\sqrt{2}}{n\omega}\sin(\omega t + \alpha) + \left(\phi_r - \frac{V\sqrt{2}}{n\omega}\sin\alpha\right)e^{-t/\tau}$$

avec

$\tau$ = L / R et L est l'inductance du bobinage inducteur.

Il est alors possible de déterminer l'intensité i(t) en fonction de la courbe B(H) du matériau magnétique du circuit.

La mise sous tension optimale du transformateur est effectuée à un angle $\alpha$ donné tel que le transitoire du flux (et donc des courants), c'est-à-dire l'intensité maximale atteinte suite à la mise sous tension, soit la plus faible possible, afin de protéger le transformateur.

A titre d'exemple, si $\Phi_r$ = 0 et $\alpha$=0 (i.e. mise sous tension au maximum de tension et absence de flux rémanent), alors :

$$\phi(t) = \frac{V\sqrt{2}}{n\omega}\sin(\omega t)$$

ce qui signifie qu'il n'y a pas de régime transitoire. La mise sous tension est donc optimale.

En revanche, si $\Phi_r$ = $\Phi_{r\,max}$ et $\alpha$=3$\pi$/2 (i.e. mise sous tension au 0 de tension et flux rémanent maximum), alors :

$$\phi(t) = -\frac{V\sqrt{2}}{n\omega}\cos(\omega t) + \left(\phi_{r\,max} + \frac{V\sqrt{2}}{n\omega}\right)e^{-t/\tau}$$

Dans ce cas, le flux prend des valeurs très élevées et entraîne un appel de courant important ou provoque d'importantes surtensions temporaires harmoniques sur le réseau.

Ces deux exemples montrent l'intérêt de connaître la valeur du flux rémanent.

Une solution connue pour évaluer le flux rémanent est basée sur le fait que la tension est homogène à la dérivée du flux, et consiste ainsi à évaluer le flux rémanent en intégrant la tension aux bornes du transformateur avant de mettre celui-ci hors tension.

Une telle méthode est décrite par exemple dans le document US 2010/0013470.

Les documents DE 196 41 116 et DE 36 14 057 divulguent également des procédés utilisant des données relatives à l'état du dispositif avant sa mise hors tension pour estimer un instant optimal de mise sous tension.

Cependant, une telle méthode indirecte de détermination du flux rémanent peut s'avérer dans certaines configurations du réseau électrique d'alimentation du transformateur peu précise et peu robuste car des phénomènes ont pu intervenir, changeant l'état magnétique du circuit magnétique, et l'imprécision de la mesure de tension, qui est la donnée d'entrée pour le calcul du flux, rend celui-ci peu précis (offset, dérive, niveau de tension faible, signal bruité).

Par ailleurs, il peut s'écouler un long laps de temps entre la mise hors tension et la mise sous tension d'un transformateur, ce qui nécessite de sauvegarder les données pendant une longue période et de mesurer le flux régulièrement pour vérifier son évolution.

Un but de l'invention est donc de permettre de contrôler de façon plus précise, simple et fiable, l'instant de mise sous tension d'un transformateur ou de tout autre dispositif comprenant un circuit magnétique et une ou plusieurs bobines conductrices parcourues en fonctionnement par un courant, tel qu'une machine tournante par exemple.

Un autre but de l'invention est de procurer un procédé simple et fiable de mise sous tension d'un transformateur dans des conditions optimales.

Un autre but de l'invention est de concevoir un système de détermination du flux rémanent dans un circuit magnétique qui soit plus performant et plus précis que les systèmes actuels et facile à mettre en oeuvre.

**BREVE DESCRIPTION DE L'INVENTION**

Conformément à l'invention, il est proposé un procédé de contrôle de l'instant de mise sous tension d'un dispositif comprenant un circuit magnétique et au moins une bobine conductrice, caractérisé en ce qu'il comprend les étapes de :

- acquisition d'au moins une mesure du champ magnétique généré par le flux rémanent dans ledit circuit magnétique par au moins un capteur de champ magnétique placé au voisinage du circuit magnétique,
- traitement des mesures de champ magnétique acquises pour en déduire le flux rémanent dans le circuit magnétique,
- à partir du flux rémanent, détermination de l'instant optimal de la mise sous tension.

L'ensemble de ces étapes est mis en oeuvre après la mise hors tension du dispositif et ne nécessite aucune connaissance ou mémorisation de l'état du dispositif au moment de sa mise hors tension.

Ledit procédé comprend avantageusement une étape préalable de calibration du capteur, dans laquelle on établit la fonction de transfert entre la valeur du champ magnétique mesuré par le capteur et la valeur du flux rémanent dans le circuit magnétique.

A cet effet, selon un premier mode de réalisation, on place au moins une paire de capteurs sur le circuit magnétique de manière symétrique par rapport audit circuit magnétique, ce qui permet d'éliminer par soustraction la composante du champ perturbateur dans les mesures acquises par les capteurs et on détermine ladite fonction de transfert en fonction des valeurs du champ magnétique mesuré par ladite paire de capteurs et de la perméabilité relative du matériau formant le circuit magnétique.

Selon une variante d'exécution du calibrage, on place au moins une paire de capteurs au voisinage du circuit magnétique de manière symétrique par rapport audit circuit magnétique, ce qui permet d'éliminer par soustraction la composante du champ perturbateur dans les mesures acquises par les capteurs ; la calibration du capteur comprend alors une étape de détermination de l'intégrale, sur une période du courant, de la tension aux bornes de la bobine au passage par zéro du courant et une étape de détermination, sur la courbe d'hystérésis de l'induction dans le circuit magnétique en fonction de l'intensité du courant circulant dans la bobine avant la mise hors tension, de l'induction au passage par zéro du courant, et la détermination de la fonction de transfert à partir desdites étapes.

Selon un mode particulier de mise en oeuvre de l'invention, ledit dispositif comprend une enceinte entourant le circuit magnétique et la bobine, et l'on place alors au moins un capteur de champ magnétique sur une face externe de ladite enceinte.

L'invention concerne également l'application du procédé précédent à la mise sous tension d'un transformateur, dans lequel on met sous tension le transformateur à l'instant optimal déterminé par ledit procédé pour chacune des phases d'alimentation.

Selon une forme d'exécution particulière de l'invention, dans laquelle ledit dispositif comprend plusieurs phases d'alimentation, on met en oeuvre le procédé plus haut pour déterminer la valeur du flux rémanent dans le circuit magnétique pour chacune des phases dudit dispositif hors tension, et on calcule l'instant optimal de mise sous tension pour la phase présentant le flux rémanent le plus élevé.

L'invention concerne également une application dudit procédé à la mise sous tension d'un transformateur triphasé, dans laquelle on met sous tension la phase d'alimentation présentant le flux rémanent le plus élevé à l'instant optimal déterminé par ledit procédé pour ladite phase d'alimentation, puis on met simultanément sous tension les autres phases d'alimentation à un instant où la tension induite par la mise sous tension de la première phase passe par une valeur nulle.

Un autre objet de l'invention concerne un système de contrôle de l'instant de mise sous tension d'un dispositif comprenant un circuit magnétique et au moins une bobine conductrice.

Ce système est remarquable en ce qu'il comprend :

- au moins un capteur de champ magnétique,
- un système d'acquisition des mesures de champ magnétique provenant dudit capteur,
- un système de traitement des données acquises par le système d'acquisition, pour calculer le flux rémanent dans le circuit magnétique et pour déterminer, à partir du flux rémanent, l'instant optimal de mise sous tension du dispositif.

Enfin, l'invention concerne également un transformateur comprenant un circuit magnétique, au moins une bobine conductrice primaire et une bobine conductrice secondaire, ledit circuit magnétique et lesdites bobines conductrices étant entourés par une enceinte, ledit transformateur étant muni, sur le circuit magnétique et/ou sur ou à proximité d'une face externe de l'enceinte, d'au moins un capteur de champ magnétique appartenant à un système tel que décrit ci-dessus.

**BREVE DESCRIPTION DES DESSINS**

D'autres caractéristiques et avantages de l'invention ressortiront de la description détaillée qui va suivre, en référence aux dessins annexés sur lesquels :

- la figure 1 est une vue schématique d'un transformateur monophasé et des capteurs de champ magnétique ;

- la figure 2A illustre un modèle numérique d'une portion d'un circuit magnétique et d'une enceinte entourant ledit circuit ;
- la figure 2B illustre les différentes valeurs de l'induction magnétique générée par le flux rémanent dans le circuit magnétique de la figure 2A à l'extérieur de l'enceinte ;
- la figure 3 illustre l'induction mesurée sur un chemin perpendiculaire à une face du circuit magnétique de la figure 2A, avec et sans l'enceinte ;
- la figure 4 illustre une courbe du flux magnétique dans le circuit magnétique en fonction de l'intensité circulant dans la bobine avant la mise hors tension ;
- la figure 5 illustre une courbe de l'induction dans le circuit magnétique en fonction de l'intensité du courant circulant dans la bobine avant la mise hors tension.

## DESCRIPTION DETAILLEE DE L'INVENTION

Le dispositif auquel s'applique le procédé comprend de manière générale un circuit magnétique, formé en un matériau ferromagnétique et une ou plusieurs bobines conductrices entourant ou non une partie du circuit magnétique et pouvant être parcourues par un courant.

Par ailleurs, le circuit magnétique et la ou les bobines conductrices peuvent être enfermés dans une enceinte, qui est typiquement une enveloppe de tôle d'acier.

Cette enceinte est notamment destinée à contenir l'huile nécessaire au refroidissement du transformateur.

Le matériau de l'enceinte ne forme pas barrière au champ de fuite provenant du circuit magnétique, de sorte qu'il est possible de mesurer le flux magnétique à la surface extérieure de l'enceinte.

Dans le cas d'un transformateur, l'une des bobines est reliée à une source d'alimentation électrique alternative, et une ou plusieurs bobines additionnelles sont reliées à un circuit électrique à alimenter.

On décrira, dans cet exemple non limitatif, un transformateur monophasé, mais la méthode s'applique dans son principe de manière similaire à tout autre dispositif, tel qu'un transformateur triphasé, une machine tournante, etc.

### Méthode de détermination du flux rémanent

D'une manière générale, la méthode est basée sur la détermination du flux rémanent dans le circuit magnétique après la mise hors tension du dispositif au moyen d'une ou plusieurs mesures du champ magnétique généré par ce flux rémanent au voisinage du circuit magnétique.

La connaissance du flux rémanent permet alors de déterminer l'instant optimal de mise sous tension.

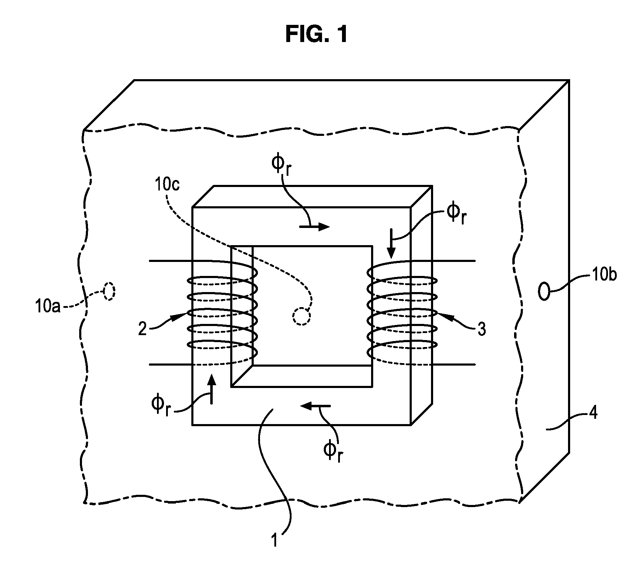

La figure 1 représente de manière schématique un transformateur monophasé.

Ce transformateur comprend un circuit magnétique 1, une bobine conductrice primaire 2 reliée à une source d'alimentation électrique alternative et une bobine conductrice secondaire 3 reliée à un circuit électrique à alimenter.

Le circuit magnétique comprend un noyau en matériau ferromagnétique qui, sur cette figure, est représenté homogène.

Toutefois, de manière conventionnelle, le circuit magnétique peut présenter une structure feuilletée formée d'une pluralité de tôles parallèles isolées les unes des autres.

Selon un mode particulier de réalisation, le circuit magnétique 1 et les bobines conductrices primaire et secondaire 2 et 3 sont entourés d'une enceinte 4 qui se présente sous la forme d'une enveloppe de tôle d'acier, représentée ici partiellement.

Lorsque le transformateur est mis hors tension, le flux circulant dans le circuit magnétique se fige après un régime transitoire et il en résulte un flux rémanent $\Phi_r$ présent dans le circuit magnétique 1.

Pour déterminer la valeur de ce flux rémanent, on place au voisinage du circuit magnétique 1 un ou plusieurs capteurs de champ magnétique.

Par « voisinage » on entend dans le présent texte que le capteur est placé soit sur le circuit magnétique lui-même, soit à une distance suffisamment faible pour que la mesure du champ magnétique permette une détermination précise du flux magnétique dans le circuit magnétique.

A titre d'exemple, on considère ici que le capteur est au voisinage du circuit magnétique s'il est situé à une distance de celui-ci qui est inférieure au plus grand côté dudit circuit magnétique.

Il existe deux sources principales de champ magnétique dans le transformateur hors tension : le flux rémanent d'une part, et un champ perturbateur (principalement constitué du champ magnétique terrestre) d'autre part.

Si d'autres champs que le champ magnétique terrestre constituent le champ perturbateur, on peut mettre en oeuvre un système de réjection de ces perturbations. Des méthodes de traitement du signal connues permettent en effet de séparer les différentes sources de champ magnétique.

Lorsque l'on effectue une mesure de champ magnétique au voisinage du circuit magnétique, la valeur mesurée résulte de ces deux sources.

Lorsqu'une enceinte entoure le circuit magnétique, il est possible de placer le ou les capteurs sur la face externe ou interne de l'enceinte ou à proximité, celle-ci n'annulant pas le champ de fuite.

En effet, il a été démontré que, de manière inattendue, l'induction relevée à l'extérieur de l'enceinte est suffisante pour permettre une mesure fiable du champ magnétique généré par le flux rémanent.

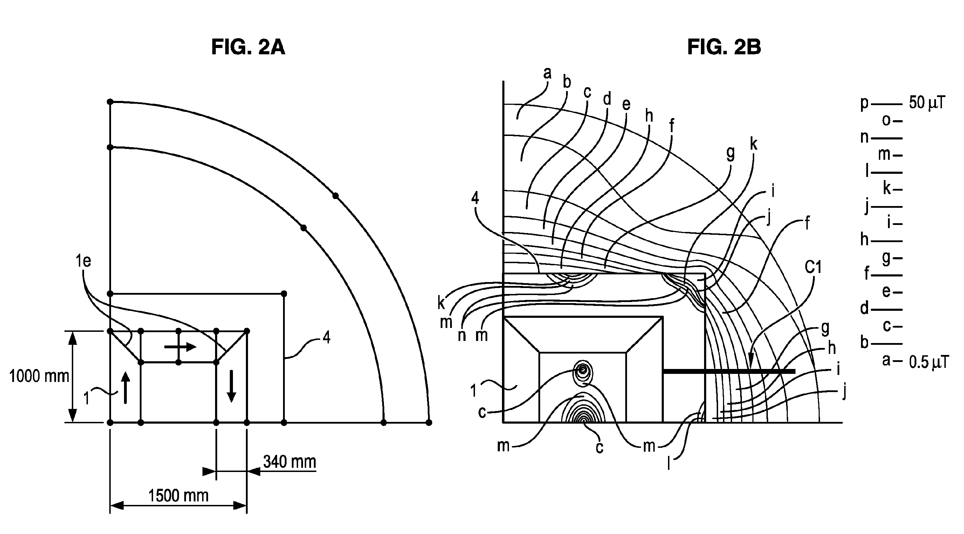

Les figures 2A à 3 présentent des simulations effectuées sur un modèle d'une portion d'un circuit et d'une enceinte entourant ladite portion.

La figure 2A illustre un modèle numérique d'une portion d'un circuit magnétique 1 et d'une enceinte 4 entourant ledit circuit.

Bien que seul un quart du circuit soit modélisé, ici à l'aide du logiciel Flux 2D, la simulation numérique porte sur la totalité du dispositif.

Le circuit magnétique est modélisé sous la forme d'un ensemble d'aimants dont chacun présente une direction d'aimantation spécifique.

Les aimants présentent une perméabilité relative $\mu_{r1}$ = 5000 et une induction rémanente $B_r$ = 1 T.

Les imperfections du circuit magnétique sont modélisées par des entrefers 1e de 0,5 mm localisés dans les coins du circuit magnétique.

Les flèches représentent l'orientation des lignes de champ magnétique dans le circuit magnétique.

L'enceinte métallique 4 présente une perméabilité relative $\mu_{r4}$ = 100 et une épaisseur de 1 cm.

La figure 2B illustre les différentes valeurs de l'induction magnétique générée par le flux rémanent dans le circuit magnétique 1 ainsi modélisé à l'extérieur de l'enceinte 4.

L'échelle de a à p correspond à des zones à iso-induction dont la valeur est comprise entre 0,5 $\mu$T et 50 $\mu$T.

Comme on peut le voir, l'induction magnétique à proximité de l'enceinte présente des valeurs suffisamment élevées pour permettre une mesure exploitable par un capteur de champ magnétique disposé dans cette zone.

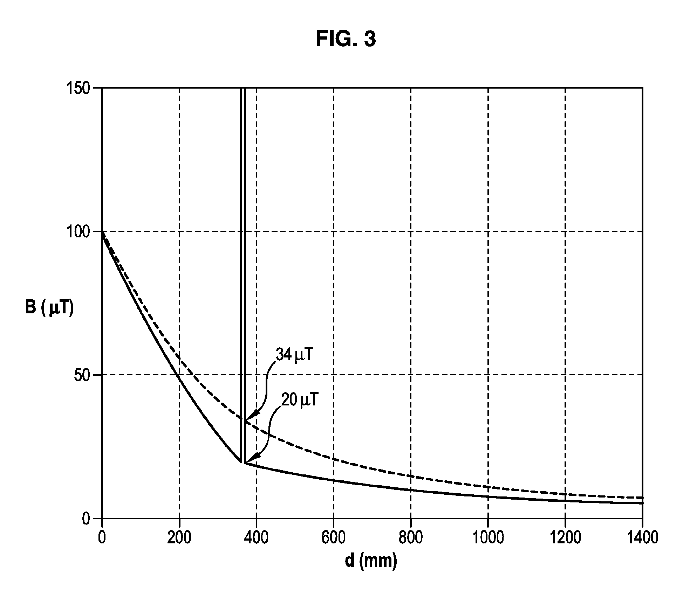

Ceci est visible sur la figure 3 qui présente l'induction magnétique B mesurée sur un chemin C1 (schématisé sur la figure 2B) perpendiculaire à une face du circuit magnétique 1, sans l'enceinte (courbe en pointillés) et avec l'enceinte (courbe en trait plein), en fonction de la distance d par rapport au circuit magnétique.

Ainsi, en présence de l'enceinte, l'induction relevée immédiatement à l'extérieur de l'enceinte est de 20 $\mu$T, tandis que l'induction mesurée au même endroit en l'absence d'enceinte est de 34 $\mu$T.

Par conséquent, même si l'enceinte altère la valeur du champ magnétique généré par le flux rémanent, il existe, à l'extérieur de l'enceinte, une trace représentative de ce champ magnétique que l'on peut mesurer et corréler à la valeur réelle grâce à une calibration adéquate.

Ceci peut s'expliquer par le fait que les champs magnétiques générés par le dispositif visé par l'invention sont suffisamment élevés pour générer une trace mesurable à l'extérieur de l'enceinte.

Dans le cas de la simulation décrite ici, une induction rémanente de 1 T du circuit magnétique est représentée par une induction mesurée à l'extérieur de l'enceinte de 20 $\mu$T.

Une induction rémanente de l'ordre de 1 mT serait donc représentée par une induction à l'extérieur de l'enceinte de l'ordre de quelques nT, qui est supérieure à la précision des capteurs présents actuellement sur le marché, et qui est donc mesurable. Une mesure par un capteur placé à l'extérieur de l'enceinte peut donc être représentative de l'induction rémanente pour autant que les perturbations extérieures puissent être négligées.

En référence à la figure 1, trois capteurs de champ magnétique 10a, 10b, 10c ont ainsi été placés sur trois faces extérieures de l'enceinte 4.

Les conditions privilégiées de positionnement et d'orientation des capteurs sont indiquées plus loin.

De préférence, on positionne le ou les capteurs dans le plan moyen du circuit magnétique, de façon à ce qu'ils soient le plus sensibles possible aux lignes de champ magnétique autour du circuit.

On emploie pour leur mise en place tout mode de fixation approprié (adhésif, etc.) vis-à-vis du circuit magnétique et/ou de l'enceinte, voire un support distinct du circuit magnétique ou de l'enceinte.

On acquiert grâce au(x) capteur(s) une ou plusieurs valeurs du champ magnétique au voisinage du circuit magnétique.

On traite ensuite la ou lesdites valeurs pour en déduire la valeur du flux rémanent dans le circuit magnétique.

En effet, comme on le verra plus loin, une calibration préalable de chaque capteur permet de déterminer la fonction de transfert entre la valeur du champ magnétique mesuré par ce capteur et la valeur du flux rémanent.

Contrôle de l'instant de mise sous tension

La connaissance du flux rémanent permet ensuite de déterminer l'instant optimal de mise sous tension.

En effet, en reprenant l'exemple d'un transformateur monophasé, si la valeur de $\Phi_r$ est connue, l'angle de mise sous tension $\alpha$ optimal pour minimiser le régime transitoire de courant se déduit des équations précédentes par la formule :

$$\frac{V\sqrt{2}}{n\omega}\sin\alpha = \phi_r$$

soit :

$$\alpha = \arcsin(\frac{\phi_r\, n\,\omega}{V\sqrt{2}})$$

L'avantage de ce procédé est de ne pas nécessiter la connaissance des conditions dans lesquels le dispositif a été mis hors tension, ce qui évite un archivage des conditions de fonctionnement du dispositif.

Par ailleurs, ce procédé est plus direct que les méthodes d'intégration de l'art antérieur, et est donc plus précis car il permet de s'affranchir des phénomènes qui ont pu se produire et modifier l'état magnétique du circuit magnétique, ainsi que des imprécisions de la mesure de tension qui est utilisée comme donnée d'entrée pour le calcul du flux dans les méthodes antérieures.

Dans le cas où le dispositif est un transformateur triphasé à trois colonnes, on mesure le flux rémanent dans chaque colonne, en plaçant au moins un capteur de champ magnétique sur le circuit magnétique de chacune des colonnes.

Pour mettre sous tension le transformateur, on met d'abord sous tension la phase pour laquelle le flux rémanent est le plus élevé, l'instant de ladite mise sous tension étant déterminé de manière à minimiser le régime transitoire de courant.

La mise sous tension de la première phase engendre une tension induite dans les deux autres phases, déphasée de 180° par rapport à la première phase.

Après un délai correspondant à quelques demi-périodes de ladite tension induite (destiné à réduire l'asymétrie du flux magnétique dans les deux phases à mettre sous tension), on met simultanément ces deux phases sous tension à un instant correspondant à un passage par zéro de la tension induite.

Cette méthode de mise sous tension est décrite dans l'article d'A. Mercier et al., « Transformer Controlled Switching taking into account the Core Residual Flux - A real case study », CIGRE 13-201, 2002, auquel on pourra se référer.

Naturellement, on pourra choisir toute autre stratégie d'enclenchement sans pour autant sortir du cadre de la présente invention.

Calibration du capteur

Les mesures effectuées au moyen des capteurs permettent une évaluation qualitative du flux rémanent, à savoir sa présence et son sens.

Pour une évaluation quantitative, c'est-à-dire pour déduire la valeur du flux rémanent dans le circuit magnétique des valeurs de champ magnétique mesurées, il est nécessaire de réaliser au préalable une calibration du capteur pour déterminer la fonction de transfert entre le champ magnétique mesuré et le flux rémanent correspondant.

Pour illustration à titre d'exemple, on présente ci-après l'utilisation de deux capteurs utilisés près d'un transformateur monophasé ne comportant pas d'enceinte.

Comme on le verra plus bas, l'avantage d'employer deux capteurs disposés de manière symétrique est de pouvoir éliminer par soustraction la composante du champ perturbateur dans les mesures acquises par lesdits capteurs.

On distingue le cas où les capteurs sont positionnés directement sur le circuit magnétique, puis le cas où les capteurs sont placés à distance du circuit magnétique.

Cas 1 : capteurs sur le circuit magnétique

Dans ce cas, on mesure la composante tangentielle du champ magnétique, dans la direction principale de l'induction dans le circuit magnétique.

Le capteur doit donc être orienté par rapport au circuit magnétique de manière à mesurer cette composante.

Ce cas est également valable lorsque l'on place le capteur suffisamment près du circuit magnétique pour pouvoir mesurer la composante tangentielle du champ magnétique à l'interface circuit - air.

L'induction mesurée par un capteur est définie par la formule :

$$B_{capteur} = A_1 \cdot B_0 + A_2 \cdot B_a$$

où :

$A_1$ est une grandeur dépendant à la fois de la position du capteur et de l'induction dans le circuit magnétique;

$B_0$ est la composante du champ perturbateur (principalement le champ magnétique terrestre) dans la direction de l'induction tangentielle ;

$B_a$ est la composante principale de l'induction dans le circuit magnétique, tangentielle à l'interface entre l'air et le circuit magnétique ;

$A_2 = 1/\mu_a$ par conservation du champ magnétique tangentiel au niveau du passage circuit - air (théorème d'Ampère) ;

$\mu_a$ est la perméabilité relative du matériau composant le circuit magnétique.

Lorsque l'on place deux capteurs de manière symétrique sur le circuit magnétique, la composante du champ perturbateur est modifiée de la même manière par la présence du circuit magnétique.

Les mesures d'induction effectuées par les deux capteurs s'écrivent donc :

$$B_{capteur\,1} = A_1 \cdot B_0 + A_2 \cdot B_a$$

$$B_{capteur\,2} = A_1 \cdot B_0 - A_2 \cdot B_a$$

La soustraction des mesures obtenues par les deux capteurs permet d'éliminer la composante du champ perturbateur et l'on obtient ainsi :

$$B_{capteur\,1} - B_{capteur\,2} = 2A_2 \cdot B_a$$

La valeur de $B_a$ peut donc être déduite des mesures obtenues au moyen des deux capteurs et de la perméabilité relative du matériau du circuit magnétique, qui est connue.

On peut alors déterminer la valeur du flux circulant dans le circuit magnétique, qui est donnée par la relation :

$$\phi_a = n \cdot B_a \cdot S_a$$

où n est le nombre de spires de la bobine inductrice et $S_a$ est la section du circuit magnétique.

*Cas 2 : capteurs à distance du circuit magnétique*

Lorsque le capteur n'est pas sur le circuit magnétique, l'induction mesurée par ce capteur a pour expression :

$$B_{capteur} = A_1 \cdot B_0 + A_2 \cdot B_a$$

où les grandeurs $A_1$, $B_0$ et $B_a$ ont les mêmes définitions que dans le cas précédent.

En revanche, le coefficient $A_2$ doit être déterminé par les étapes suivantes :

1) Mesure de la tension primaire ou secondaire (notée V), de l'induction magnétique (notée B) mesurée par un capteur et du courant primaire (noté I) lorsque le transformateur (à vide) est alimenté sous tension alternative.

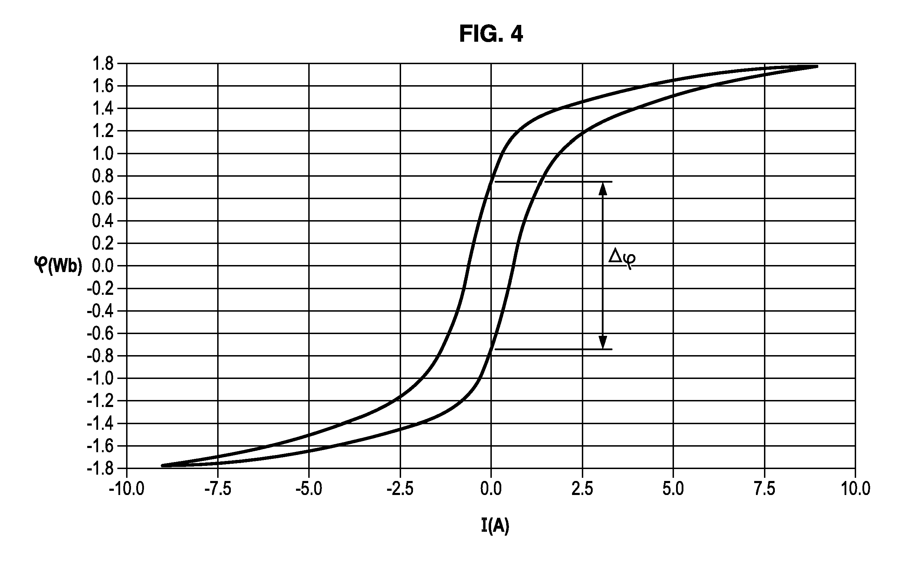

2) Tracé de la courbe φ(I) où φ est défini comme l'intégrale de la tension V en fonction du temps sur une période du courant (soit 20 ms à 50 Hz). Cette courbe est illustrée à la figure 4. Elle est obtenue d'une part en calculant, sur une période de courant, l'intégrale φ de la tension en fonction du temps (qui présente une forme sinusoïdale déphasée de 90° par rapport à la tension V), et d'autre part en mesurant la variation du courant I sur la même période, et en traçant, à partir de ces deux séries de données, la courbe d'hystérésis φ(I). Une telle courbe, ainsi que les formes d'onde de la tension, du flux et du courant sont illustrées par exemple à la page 455 de l'ouvrage Electrotechnique - 3ème édition, de Théodore Wildi, De Boeck Supérieur, 2003.

Il est à noter qu'ici, l'intégration est effectuée sur une période du courant, en vue de déterminer la fonction de transfert du capteur. Cette intégration n'est donc pas affectée par des dérives, contrairement aux méthodes antérieures citées plus haut, qui utilisent une intégration de la tension sur une longue durée pour en déduire le flux rémanent.

De manière alternative, on peut construire la courbe d'hystérésis $\varphi(I)$ à partir de la courbe de saturation du transformateur, qui est fournie par le constructeur du transformateur. Ladite courbe de saturation, qui est tracée à l'aide d'une série d'essais à vide, est une courbe non linéaire de la tension aux bornes du bobinage primaire en fonction de l'intensité. On peut tracer la courbe d'hystérésis $\varphi(I)$ correspondante grâce à un logiciel de simulation adapté tel que le logiciel EMTP.

3) Sur la courbe $\varphi(I)$, mesure de la grandeur $\Delta\varphi$ qui correspond à la différence entre les valeurs minimale et maximale de $\varphi$ au passage par zéro du courant (i.e. I = 0).

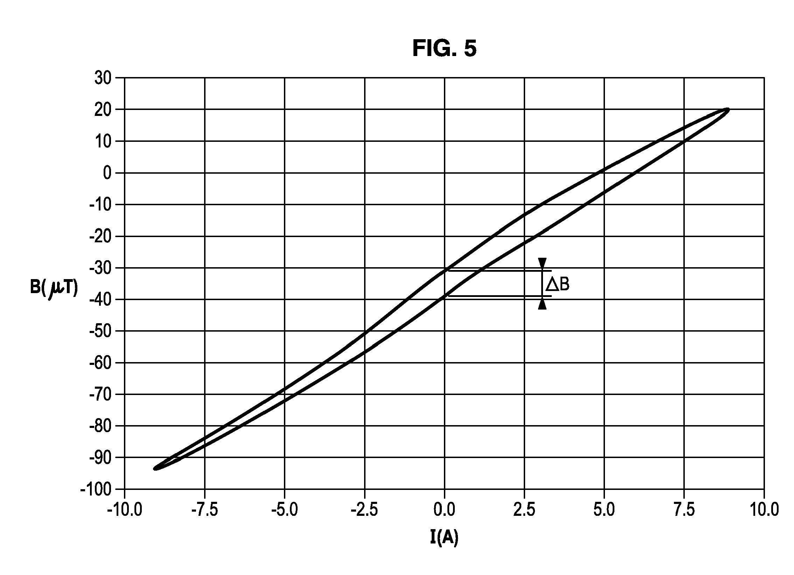

4) Tracé de la courbe B(I) illustrée à la figure 5 à partir des mesures de l'induction magnétique obtenues par le capteur à différents instants et des mesures du courant primaire aux mêmes instants lorsque le transformateur (à vide) est alimenté sous tension alternative.

5) Sur la courbe B(I), mesure de la grandeur $\Delta B$ qui correspond à la différence entre les valeurs minimale et maximale de B au passage par zéro du courant.

6) Calcul de $A_2$ par la formule suivante :

$$A_2 = \frac{\Delta B}{\Delta\varphi / (n \cdot Sa)}$$

où n est le nombre de spires de la bobine inductrice et $S_a$ est la section du circuit magnétique.

Lorsque l'on place deux capteurs de manière symétrique par rapport au circuit magnétique et au champ perturbateur, la composante du champ perturbateur est modifiée de la même manière par la présence du circuit magnétique.

Les mesures d'induction effectuées par les deux capteurs s'écrivent donc :

$$B_{capteur1} = A_1 \cdot B_0 + A_2 \cdot B_a$$

$$B_{capteur2} = A_1 \cdot B_0 - A_2 \cdot B_a$$

Connaissant $A_2$, il est possible d'en déduire $B_a$ à partir des mesures effectuées par les deux capteurs grâce à la soustraction qui permet d'éliminer la composante du champ perturbateur :

$$B_{capteur1} - B_{capteur2} = 2A_2 \cdot B_a$$

On peut alors déterminer la valeur du flux circulant dans le circuit magnétique, qui est donnée par la relation :

$$\phi_a = n \cdot B_a \cdot S_a$$

Capteurs de champ magnétique

Le système de mesure comprend au moins un capteur de champ magnétique.

Il existe des capteurs de ce type sur le marché et l'homme du métier est à même de choisir le modèle de capteur approprié.

De manière avantageuse, les capteurs sont des magnétomètres vectoriels de type « fluxgate » à un ou trois axes, adaptés pour mesurer la composante du champ magnétique selon le ou les axes considérés.

Des magnétomètres de ce type sont par exemple disponibles chez Bartington Instruments, sous la référence Mag-03.

Lorsque le capteur est un magnétomètre à un seul axe, et que l'on souhaite le positionner directement sur le circuit magnétique, on fait en sorte que son axe soit parallèle à la direction principale de l'induction dans le circuit magnétique, afin de mesurer la composante tangentielle du flux.

Les capteurs peuvent également être des magnétomètres scalaires, mesurant le module du champ magnétique. Il est alors nécessaire d'orienter ces capteurs dans une direction parallèle à celle du flux dans le circuit magnétique.

Selon la géométrie du circuit magnétique, il peut être judicieux d'employer au moins deux capteurs disposés de manière à faciliter ou à rendre plus précise la détermination du flux rémanent.

Ainsi, par exemple, on peut disposer deux capteurs de manière symétrique sur chaque portion du circuit magnétique (dans cet exemple sur chaque jambe) d'un transformateur monophasé ou triphasé à trois colonnes.

En effet, comme évoqué plus haut, un positionnement symétrique des capteurs permet de s'affranchir de l'influence du champ magnétique terrestre.

Celui-ci induisant un flux magnétique orienté du haut vers le bas dans le circuit magnétique, le positionnement des capteurs de sorte à obtenir des composantes de signes opposés pour le flux rémanent permet d'éliminer l'effet du champ perturbateur.

Par ailleurs, notamment dans les dispositifs complexes, le fait de positionner le capteur directement sur le circuit magnétique permet de négliger les phénomènes parasites.

Le nombre de capteurs peut également varier selon la méthode de calcul du flux rémanent.

En principe, un petit nombre de capteurs est suffisant, par exemple un par portion du circuit magnétique pour un transformateur.

Cependant, il est également possible de déterminer le flux rémanent à partir d'une pluralité de mesures ponctuelles du champ magnétique, selon la méthode décrite dans le document WO 02/101405.

Dans ce cas, il convient de placer autour du circuit magnétique une pluralité de capteurs de champ magnétique.

Par ailleurs, le ou les capteurs de champ magnétique peuvent être placés directement sur le circuit magnétique.

Cependant, une telle configuration peut être dans certains cas difficile à mettre en oeuvre, car l'environnement immédiat du circuit magnétique peut être défavorable à l'installation et au fonctionnement des capteurs (par exemple, présence de fluides, haute température, etc.).

Dans ce cas, il est également possible de placer le ou les capteurs sur ou à proximité de l'enceinte qui entoure le circuit magnétique.

Lorsque l'on connaît la répartition du champ magnétique autour du circuit (par exemple, au moyen d'une cartographie théorique ou expérimentale), on positionne le ou les capteurs aux emplacements où le champ magnétique est le plus intense.

Dans des situations où l'on ne connaît pas la répartition du champ magnétique et/ou les emplacements pour positionner les capteurs sont limités, on s'efforce de mettre en place des paires de capteurs de manière symétrique par rapport au champ perturbateur.

Cette solution distante du circuit magnétique présente l'avantage de ne pas être intrusive, et de pouvoir être mise en oeuvre sur des dispositifs existants sans modification de ceux-ci.

Le ou les capteurs se trouvent alors à une distance du circuit magnétique qui est inférieure à la dimension du circuit, ce qui permet une mesure suffisamment précise du champ magnétique.

Les capteurs peuvent être installés de manière permanente sur l'enceinte.

Ceci permet, le cas échéant, de faire des mesures en temps réel de l'état magnétique du circuit magnétique lorsque le dispositif est sous tension, à des fins de diagnostic.

Une autre application possible de l'invention est le contrôle suite à un traitement du transformateur visant à annuler ou à modifier le flux rémanent dans le circuit magnétique au moyen d'une source externe. Les mesures effectuées au moyen des capteurs permettent alors de vérifier si le traitement a effectivement permis d'obtenir le flux souhaité dans le circuit magnétique.

L'invention peut également être implémentée pour le contrôle du démarrage d'une machine tournante, en permettant de mesurer le flux rémanent dans une machine non alimentée.

Système d'acquisition

Le système d'acquisition est adapté pour collecter les données provenant des différents capteurs, les enregistrer et les transmettre au système de traitement.

Système de traitement

Le système de traitement est typiquement un processeur muni de moyens pour calculer, à partir des signaux acquis par le système d'acquisition, la valeur du flux rémanent dans le circuit magnétique.

En particulier, le processeur peut être adapté pour, à partir du signal associé à chaque capteur, calculer le flux rémanent à partir de la fonction de transfert dudit capteur.

Les systèmes d'acquisition et de traitement peuvent être intégrés au dispositif à contrôler, par exemple, dans le cas du transformateur décrit plus haut, dans un boîtier fixé à l'extérieur de l'enceinte, ou bien installés sur un site distant.

La connexion entre les capteurs et les systèmes d'acquisition et de traitement est effectuée par tout moyen de connexion électrique appropriée.

Enfin, il va de soi que les exemples que l'on vient de donner ne sont que des illustrations particulières en aucun cas limitatives quant aux domaines d'application de l'invention.

**Revendications**

1. Procédé de contrôle de l'instant de mise sous tension d'un dispositif comprenant un circuit magnétique (1) et au moins une bobine conductrice (2), **caractérisé en ce qu'**il comprend les étapes de :

   - acquisition d'au moins une mesure du champ magnétique généré par le flux rémanent dans ledit circuit magnétique (1) par au moins un capteur de champ magnétique (10a, 10b, 10c) placé au voisinage du circuit magnétique (1),
   - traitement des mesures de champ magnétique acquises pour en déduire le flux rémanent dans le circuit magnétique (1),
   - à partir du flux rémanent, détermination de l'instant optimal de la mise sous tension,

   l'ensemble desdites étapes étant réalisé après la mise hors tension du dispositif.

2. Procédé selon la revendication 1, **caractérisé en ce qu'**il comprend une étape préalable de calibration du capteur (10a, 10b, 10c), dans laquelle on établit la fonction de transfert entre la valeur du champ magnétique mesuré par le capteur et la valeur du flux rémanent dans le circuit magnétique (1).

3. Procédé selon la revendication 2, **caractérisé en ce que** l'on place au moins une paire de capteurs sur le circuit magnétique de manière symétrique par rapport audit circuit magnétique et **en ce que** l'on détermine la fonction de transfert en fonction des valeurs du champ magnétique mesuré par ladite paire de capteurs et de la perméabilité relative du matériau formant le circuit magnétique.

4. Procédé selon la revendication 2, **caractérisé en ce que** l'on place au moins une paire de capteurs au voisinage du circuit magnétique de manière symétrique par rapport audit circuit magnétique et **en ce que** la calibration du capteur comprend une étape de détermination de l'intégrale, sur une période du courant, de la tension aux bornes de la bobine au passage par zéro du courant et une étape de détermination, sur la courbe d'hystérésis de l'induction dans le circuit magnétique en fonction de l'intensité du courant circulant dans la bobine avant la mise hors tension, de l'induction au passage par zéro du courant, et la détermination de la fonction de transfert à partir desdites étapes.

5. Procédé selon l'une des revendications 1 à 4, **caractérisé en ce que** ledit dispositif comprend une enceinte (4) entourant le circuit magnétique (1) et la bobine (2), et **en ce que** l'on place au moins un capteur de champ magnétique (10a, 10b, 10c) sur une face externe de ladite enceinte (4).

6. Procédé selon l'une des revendications 1 à 5, **caractérisé en ce que** ledit dispositif comprend plusieurs phases d'alimentation, **caractérisé en ce qu'**il comprend la mise en oeuvre du procédé selon l'une des revendications 1 à 5 pour déterminer la valeur du flux rémanent dans le circuit magnétique pour chacune des phases dudit dispositif hors tension, et calculer l'instant optimal de mise sous tension pour la phase présentant le flux rémanent le plus élevé.

7. Application du procédé selon la revendication 6 à la mise sous tension d'un transformateur triphasé, dans laquelle on met sous tension la phase d'alimentation présentant le flux rémanent le plus élevé à l'instant optimal déterminé par ledit procédé pour ladite phase d'alimentation, puis on met simultanément sous tension les autres phases d'alimentation à un instant où la tension induite par la mise sous tension de la première phase passe par une valeur nulle.

8. Système de contrôle de l'instant de mise sous tension d'un dispositif comprenant un circuit magnétique (1) et au moins une bobine conductrice (2), le système comprenant :

   - au moins un capteur de champ magnétique (10a, 10b, 10c),
   - un système d'acquisition des mesures de champ magnétique provenant dudit capteur,
   - un système de traitement des données acquises par le système d'acquisition, pour calculer le(s) flux rémanent(s) dans le circuit magnétique et pour déterminer, à partir du flux rémanent, l'instant optimal de mise sous tension.

**caractérisé en ce que** le système est configuré tel que l'ensemble des étapes suivantes :

- acquisition d'au moins une mesure du champ magnétique généré par le flux rémanent dans ledit circuit magnétique (1) par le au moins un capteur de champ magnétique (10a, 10b, 10c) placé au voisinage du circuit magnétique (1),
- traitement des mesures de champ magnétique acquises pour en déduire le flux rémanent dans le circuit magnétique (1), à partir du flux rémanent,
- détermination de l'instant optimal de la mise sous tension,

est réalisé après la mise hors tension du dispositif.

**9.** Transformateur comprenant un circuit magnétique (1), au moins une bobine conductrice primaire (2) et une bobine conductrice secondaire (3), ledit circuit magnétique et lesdites bobines conductrices étant entourés par une enceinte (4), **caractérisé en ce qu'**il comprend, sur le circuit magnétique et/ou sur ou à proximité d'une face externe de l'enceinte (4), au moins un capteur de champ magnétique (10a, 10b, 10c) appartenant à un système selon la revendication 8.

**Patentansprüche**

**1.** Verfahren zur Steuerung des Zeitpunkts, in dem eine einen magnetischen Kreis (1) und wenigstens eine leitfähige Spule (2) aufweisende Vorrichtung unter Spannung gesetzt wird, **dadurch gekennzeichnet, dass** es folgende Schritte aufweist:

- Gewinnung wenigstens einer Messung des magnetischen Feldes, das durch den remanenten Fluss in dem magnetischen Kreis (1) erzeugt wird, mit wenigstens einem Magnetfeldsensor (10a, 10b, 10c), der in der Nähe des magnetischen Kreises (1) angeordnet ist,
- Verarbeitung der gewonnenen Magnetfeldmessungen zur Herleitung des remanenten Flusses in dem magnetischen Kreis (1) aus diesen,
- ausgehend vom remanenten Fluss, Bestimmung des optimalen Zeitpunkts des Unterspannungsetzens,

wobei die Gesamtheit der Schritte durchgeführt wird, nachdem die Vorrichtung spannungslos gesetzt ist.

**2.** Verfahren nach Anspruch 1, **dadurch gekennzeichnet, dass** es einen vorangehenden Schritt der Eichung des Sensors (10a, 10b, 10c) aufweist, in dem eine Transferfunktion zwischen dem mit dem Sensor gemessenen Wert des Magnetfelds und dem remanenten Fluss in dem magnetischen Kreis (1) hergestellt wird.

**3.** Verfahren nach Anspruch 2, **dadurch gekennzeichnet, dass** wenigstens ein Paar von Sensoren in symmetrischer Weise in Bezug auf den magnetischen Kreis an dem magnetischen Kreis angeordnet wird und dass die Transferfunktion in Abhängigkeit von den Werten des mit dem Paar von Sensoren gemessenen Magnetfelds und der relativen Permeabilität des den magnetischen Kreis bildenden Materials gewonnen wird.

**4.** Verfahren nach Anspruch 2, **dadurch gekennzeichnet, dass** wenigstens ein Paar von Sensoren in der Nähe des magnetischen Kreises in symmetrischer Weise in Bezug auf den magnetischen Kreis angeordnet wird, und dass die Eichung des Sensors einen Schritt der Bestimmung des Integrals, über einer Periode des Stroms, der Spannung an den Klemmen der Spule beim Nulldurchgang des Stroms und einen Schritt der Bestimmung, auf der Hysteresekurve der Induktion in dem magnetischen Kreis in Abhängigkeit von der Stärke des Stroms in der Spule vor dem Unterspannungsetzen, der Induktion beim Nulldurchgang des Stromes und die Bestimmung der Transferfunktion anhand der genannten Schritte umfasst.

**5.** Verfahren nach einem der Ansprüche 1 bis 4, **dadurch gekennzeichnet, dass** die Vorrichtung ein den magnetischen Kreis (1) und die Spule (2) umgebendes Gehäuse aufweist, und dass wenigstens ein Magnetfeldsensor (10a, 10b, 10c) an der Außenseite des Gehäuses (4) angeordnet wird.

**6.** Verfahren nach einem der Ansprüche 1 bis 5, **dadurch gekennzeichnet, dass** die Vorrichtung mehrere Speisephasen aufweist, **dadurch gekennzeichnet, dass** es die Durchführung des Verfahrens nach einem der Ansprüche 1 bis 5 zur Bestimmung des Wertes des remanenten Flusses in dem magnetischen Kreis für jede der Phasen der Vorrichtung ohne Spannung und das Berechnen des optimalen Zeitpunkts des Unterspannungsetzens für die den höchsten remanenten Fluss aufweisende Phase umfasst.

7. Verwendung des Verfahrens nach Anspruch 6 zum Unterspannungsetzen eines dreiphasigen Transformators, bei welchem die Speisephase, die den höchsten remanenten Fluss hat, in dem optimalen Zeitpunkt, der mit dem Verfahren für diese Speisephase bestimmt wird, unter Spannung gesetzt wird, dann gleichzeitig die anderen Speisephasen in einem Zeitpunkt, in dem die Spannung, die durch das Unterspannungsetzen der ersten Phase induziert wird, durch einen Wert null geht, unter Spannung gesetzt werden.

8. Einrichtung zur Steuerung des Zeitpunkts des Unterspannungsetzens einer Vorrichtung, welche einen magnetischen Kreis (1) und wenigstens eine leitfähige Spule (2) aufweist, wobei die Einrichtung aufweist:

  - wenigstens einen Magnetfeldsensor (10a, 10b, 10c),
  - eine Einrichtung zur Gewinnung von Messungen des Magnetfelds, die dem Sensor entstammen,
  - eine Einrichtung zur Verarbeitung von mit der Gewinnungseinrichtung gewonnenen Daten zur Berechnung des remanenten Flusses (der remanenten Flüsse) in dem magnetischen Kreis und zur Bestimmung, anhand des remanenten Flusses, des optimalen Zeitpunkts des Unterspannungsetzens, **dadurch gekennzeichnet, dass** die Einrichtung so aufgebaut ist, dass die Gesamtheit der folgenden Schritte:
  - Gewinnung wenigstens einer Messung des durch den remanenten Fluss in dem magnetischen Kreis (1) erzeugten Magnetfelds mit wenigstens einem Magnetfeldsensor (10a, 10b, 10c), der in der Nähe des magnetischen Kreises (1) angeordnet ist,
  - Verarbeitung der gewonnen Magnetfeldmessungen zur Herleitung aus diesen des remanenten Flusses in dem magnetischen Kreis (1), anhand des remanenten Flusses
  - Bestimmung des optimalen Zeitpunkts des Unterspannungsetzens,

  nach dem Spannungslossetzen der Vorrichtung durchgeführt wird.

9. Transformator, welcher einen magnetischen Kreis (1), wenigstens eine leitfähige Primärspule (2) und leitfähige Sekundärspule (3) aufweist, wobei der magnetische Kreis und die leitfähigen Spulen von einem Gehäuse (4) umgeben sind, **dadurch gekennzeichnet, dass** er an dem magnetischen Kreis und/oder an einer oder in der Nähe einer Außenfläche des Gehäuses (4) wenigstens einen Magnetfeldsensor (10a, 10b, 10c) aufweist, der zu einer Einrichtung gemäß Anspruch 8 gehört.

## Claims

1. A method for controlling the switching time of a device including a magnetic circuit (1) and at least one conductive winding (2), **characterized in that** it comprises the steps of:

  - acquiring at least one measurement of the magnetic field generated by the residual flux in said magnetic circuit (1) using at least one magnetic field sensor (10a, 10b, 10c) placed in the vicinity of the magnetic circuit (1),
  - processing the acquired magnetic field measurements to infer therefrom the residual flux in the magnetic circuit (1),
  - from the residual flux, determining the optimal switching time for energizing the device,

  all said steps being performed after de-energizing the device.

2. The method according to claim 1, **characterized in that** it comprises a prior calibration step of the sensor (10a, 10b, 10c) whereby the transfer function between the value of the magnetic field measured by the sensor and the value of the residual flux in the magnetic circuit (1) is determined.

3. The method according to claim 2, **characterized in that** at least one pair of sensors is placed on the magnetic circuit symmetrically relative to said magnetic circuit, and **in that** the transfer function is determined in relation to the values of the magnetic field measured by said pair of sensors and in relation to the relative permeability of the constituent material of the magnetic circuit.

4. The method according to claim 2, **characterized in that** at least one pair of sensors is placed in the vicinity of the magnetic circuit symmetrically relative to said magnetic circuit, and **in that** the calibration of the sensor comprises a step to determine the integral, over a current period, of the voltage at the terminals of the winding when the current crosses zero, and a determination step, on the hysteresis curve of induction in the magnetic circuit as a function of intensity of the current circulating in the winding before de-energizing, to determine induction when the current crosses zero, and determining of the transfer function from said steps.

5. The method according to one of claims 1 to 4, **characterized in that** said device comprises an enclosure (4) surrounding the magnetic circuit (1) and the winding (2), and **in that** at least one magnetic field sensor (10a, 10b, 10c) is placed on an outer surface of said enclosure (4).

6. The method according to one of claims 1 to 5, wherein said device comprises several power input phases, **characterized in that** it comprises the implementing of the method according to one of claims 1 to 5 to determine the value of the residual flux in the magnetic circuit for each of the phases of said deenergized device, and to calculate the optimal switching time for the phase having the highest residual flux.

7. Application of the method according to claim 6 to the energizing of a three-phase transformer whereby the power input phase having the highest residual flux is energized at the optimal time determined by the said method for the said input phase, then the other input phases are simultaneously energized at a time when the voltage induced by energizing the first phase crosses a zero value.

8. A system for controlling the switching time of a device including a magnetic circuit (1) and at least one conductive winding (2), the system comprising:

- at least one magnetic field sensor (10a, 10b, 10c);
- a system for acquiring the magnetic field measurements performed by said sensor;
- a system for processing the data acquired by the acquisition system, to calculate the residual flux(es) in the magnetic circuit and, from the residual flux, to determine the optimal switching time,

**characterized in that** the system is configured such that all the following steps:

- acquiring at least one measurement of the magnetic field generated by the residual flux in the said magnetic circuit (1) using the at least one magnetic field sensor (10a, 10b, 10c) placed in the vicinity of the magnetic circuit (1),
- processing the acquired magnetic field measurements to infer therefrom the residual flux in the magnetic circuit (1), from the residual flux,
- determining the optimal switching time for energizing the device,

are performed after de-energizing the device.

9. A transformer comprising a magnetic circuit (1), at least one primary conductive winding (2) and a secondary conductive winding (3), said magnetic circuit and said conductive windings being surrounded by an enclosure (4) **characterized in that**, on the magnetic circuit and/or on or in the vicinity of an outer surface of the enclosure (4), it comprises at least one magnetic field sensor (10a, 10b, 10c) belonging to a system according to claim 8.

**FIG. 1**

FIG. 2A

FIG. 2B

1e

1000 mm

1

340 mm

1500 mm

4

a
b
c
d
e
h
f
g
k
4
i
j
f
C1
k
m
n m
g
h
i
j
1
c
m
c
m
l

p ——— 50 μT
o —
n —
m —
l —
k —
j —
i —
h —
g —
f —
e —
d —
c —
b —
a — 0.5 μT

EP 2 710 393 B1

## FIG. 3

FIG. 4

EP 2 710 393 B1

**FIG. 5**

EP 2 710 393 B1

## RÉFÉRENCES CITÉES DANS LA DESCRIPTION

**Documents brevets cités dans la description**

- US 20100013470 A
- DE 19641116
- DE 3614057
- WO 02101405 A

**Littérature non-brevet citée dans la description**

- **D'A. MERCIER et al.** Transformer Controlled Switching taking into account the Core Residual Flux - A real case study. *CIGRE,* 2002, 13-201
- **THÉODORE WILDI.** Electrotechnique. De Boeck Supérieur, 2003, 455